# EUROPEAN PATENT APPLICATION

(11) **EP 2 701 283 A1**
(43) Date of publication of application: **26.02.2014**
(21) Application number: 12774262.5
(22) Date of filing: 20.04.2012
(51) Int. Cl.: H02J 17/00, H05K 9/00

(54) **RESONANCE-TYPE NON-CONTACT POWER SUPPLY SYSTEM**

(30) Priority: 22.04.2011 JP 2011096365
(71) Applicant: Yazaki Corporation, Minato-ku Tokyo 108-8333 (JP)
(72) Inventor: NGAHU Antony, Susono-City Shizuoka-ken 410-1194 (JP); YANAGIDA You, Susono-City Shizuoka-ken 410-1194 (JP); NAKAHARA Takahiro, Susono-City Shizuoka-ken 410-1194 (JP)
(74) Representative: Grünecker, Kinkeldey, Stockmair & Schwanhäusser
(86) International application number: PCT/JP2012/060794
(87) International publication number: WO 2012/144637

(57) **Abstract**

A resonance-type non-contact power supply system (10) includes a transmitting side metal shield (80) to cover an area around a primary coil (30) and a primary resonance coil (35). One end of a coaxial cable outer conductor (64) of a transmitting side coaxial cable (60) is connected to a shield bottom (84) of the transmitting side metal shield (80), and the other end of the coaxial cable outer conductor (64) is connected to a power supply housing (24) of a high frequency power supply (20).

## Description

### Technical Field

The present invention relates to a resonance-type non-contact power supply system.

### Background Art

A technique in which electric power is supplied to a load device by a non-contact system is known. As a product into which the technique is applied, a mobile phone charging system has become popular in general. Furthermore, in recent years, the non-contact power supply system is practically used even as a system to charge electric cars, and various standards are established.

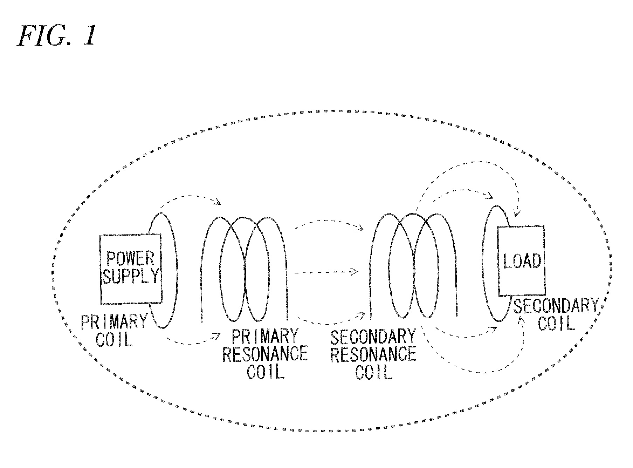

There are various types of non-contact power supply systems. The power supply system for electric cars is resonance-type non-contact power supply system shown in Fig. 1 which greatly attracts attentions and whose basic principle is developed and demonstrated by MIT (Massachusetts Institute of Technology) (for example, refer to a patent document 1). In the resonance-type non-contact power supply system shown in the figure, a high frequency power supply and a transmitting loop (primary coil) are directly connected, and a receiving loop (secondary coil) and a load are directly connected. The system is a resonance system that transmits electric power contactlessly. Specifically, transmitting side (primary) devices include the high frequency power supply, the transmitting loop, and a primary resonance coil. Receiving side (secondary) devices include a secondary resonance coil, the secondary coil and the load. The transmitting side devices and the receiving side devices in the system have an advantage of being able to supply electric power to a place spaced several meters with a high transmission efficiency (sometimes around 50%) by being magnetically coupled (electromagnetically coupled) by resonance.

### Related art documents

### Patent documents

Patent document 1: Japan Patent Publication No. 2009-501510

### Summary of Invention

### Technical Problem

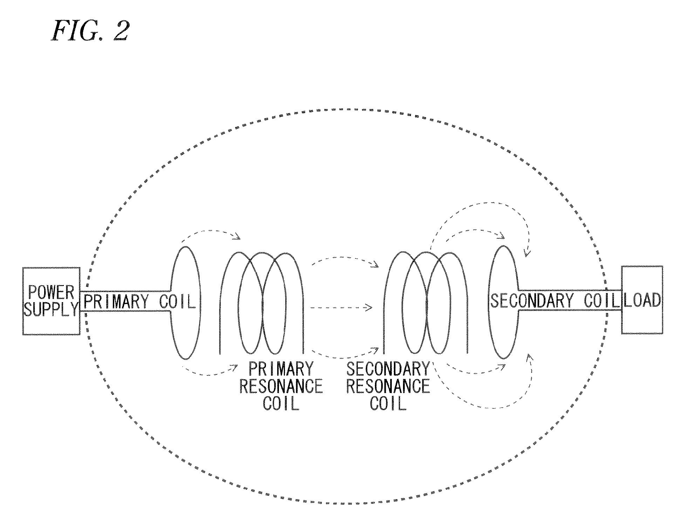

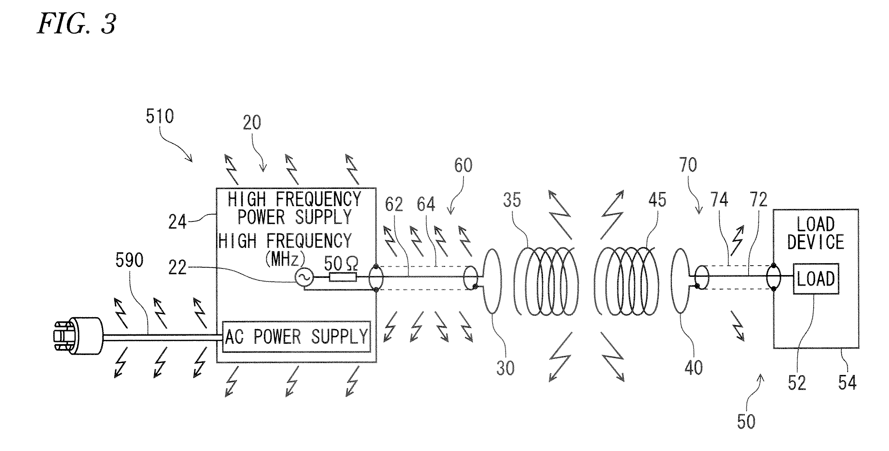

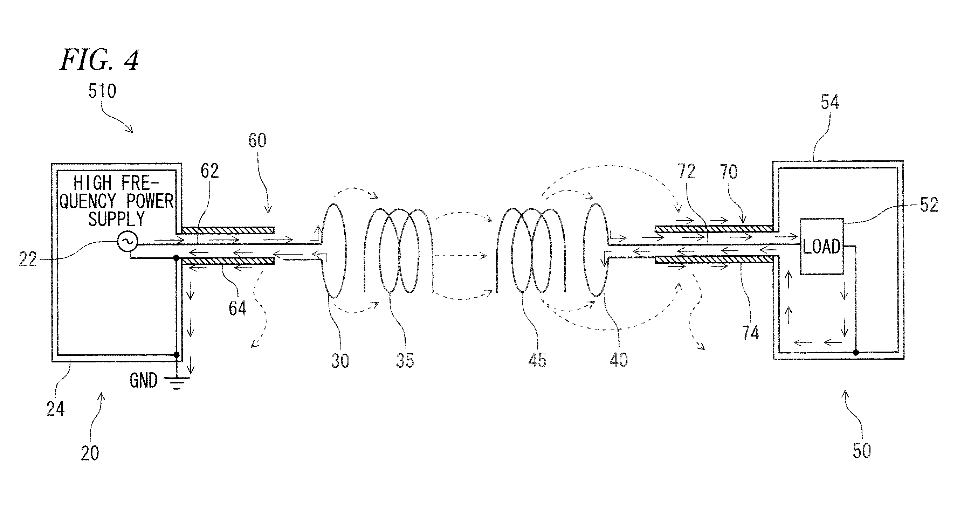

In the technique of MIT shown in Fig. 1, it is assumed that "a power supply part (the high frequency power supply and the transmitting loop), a resonance part (the primary resonance coil and the secondary resonance coil), and a load part (the receiving loop and the load)" become the resonance system. However, additional components become necessary when the non-contact power supply system is mounted in an electronic device or automobile power supply system. A system construction example when the system of Fig. 1 is mounted in a real system is shown in Fig. 2. As shown in the figure, in the real system, a transmission channel between the power supply and a primary resonance part and a transmission channel between a secondary resonance part and the load are necessary, and these transmission channels are included in the resonance system. Therefore, electromagnetic coupling also occurs in the transmission channels (transmission lines). As a result, there is a problem that a radiated electromagnetic field is caused by an induced current from a power supply housing and the FG line of an AC line. More specifically, for example, as shown in the traditional resonance-type non-contact power supply system 510 of Fig. 3, coaxial cables (a transmitting side coaxial cable 60 and a receiving side coaxial cable 70) are often used in the transmission channels connected to a primary resonance coil 35 and a secondary resonance coil 45. Electric power is supplied to the high frequency power supply 20 by using an AC cable 590. Radiated electromagnetic fields occur around these coaxial cables (60, 70) or the AC cable 590. As shown in Fig. 4, when the coaxial cables (60, 70) are used in the transmission channels connected to the primary resonance coil 35 and the secondary resonance coil 45 of the resonance-type non-contact power supply system 510, there is a merit that unevenness in characteristic impedance and transmission loss can be reduced, but an induced current flows particularly into the ground (GND) of the power supply through the outside of a coaxial cable outer conductor 64 from the joining part of the transmitting side coaxial cable 60 and the primary coil 30. Therefore, radiated electromagnetic field from the primary side occurs. At the secondary side, all of the electromagnetic field is not coupled from the secondary resonance coil 45 to the secondary coil 40, part of the electromagnetic field is coupled with a coaxial cable outer conductor 74, and an induced current, which becomes a transmission loss, occurs. This is the cause of the radiated electromagnetic field.

As a typical measure, a technique is considered to shield the whole radiation source, that is, to shield the power supply housing 24 and the AC cable 590. However, because the technique causes troubles in operating the power supply, or the radiation source may have to be shielded considerably farther than the outlet, more realistic techniques are demanded.

The invention is made in view of these situations, and the object of the invention is to provide a technique to solve the above problems.

### Solution to Problem

According to one aspect of the present invention, there is provided a resonance-type non-contact power supply system which comprises a transmitting side resonance coil part and a receiving side resonance coil part, and which transmits electric power by a non-contact resonance effect from the transmitting side resonance coil part to the receiving side resonance coil part, further comprising a transmitting side coaxial cable which electrically connects a high frequency power supply and the transmitting side resonance coil, and a good conductor first transmitting side shielding part which covers the transmitting side resonance coil part from the outside, wherein an outer conductor of the transmitting side coaxial cable connects the first transmitting side shielding part and a housing of the high frequency power supply.

The resonance-type non-contact power supply system may further comprise a receiving side coaxial cable which electrically connects a load device and the receiving side resonance coil part, and a good conductor first receiving side shielding part which covers the receiving side resonance coil part from the outside, wherein an outer conductor of the receiving side coaxial cable connects the first receiving side shielding part and a housing of the load device.

The resonance-type non-contact power supply system may further comprise a good conductor second transmitting side shielding part which covers the first transmitting side shielding part from the outside, and a good conductor transmitting side coaxial cable shielding part which covers the transmitting side coaxial cable and electrically connects the second transmitting side shielding part and the housing of the high frequency power supply.

The resonance-type non-contact power supply system may further comprise a good conductor second transmitting side shielding part which covers the first transmitting side shielding part from the outside, a good conductor transmitting side coaxial cable shielding part which covers the transmitting side coaxial cable and electrically connects the second transmitting side shielding part and the housing of the high frequency power supply, a good conductor second receiving side shielding part which covers the first receiving side shielding part from the outside, and a good conductor receiving side coaxial cable shielding part which covers the receiving side coaxial cable and electrically connects the second receiving side shielding part and a housing which covers the housing of the load device.

The second transmitting side shielding part and the second receiving side shielding part may comprise surfaces which extend outwards respectively from the ends of the second transmitting side shielding part and the second receiving side shielding part that face each other.

According to another aspect of the present invention, there is provided a resonance-type non-contact power supply system which comprises a transmitting side resonance coil part and a receiving side resonance coil part, and which transmits electric power by a non-contact resonance effect from the transmitting side resonance coil part to the receiving side resonance coil part, further comprising a receiving side coaxial cable which electrically connects a load device and the receiving side resonance coil part, and a good conductor first receiving side shielding part which covers the receiving side resonance coil part from an outside, wherein an outer conductor of the receiving side coaxial cable connects the first receiving side shielding part and a housing of the load device.

The resonance-type non-contact power supply system may further comprise a good conductor second receiving side shielding part which covers the first receiving side shielding part from the outside, and a good conductor receiving side coaxial cable shielding part which covers the receiving side coaxial cable and electrically connects the second receiving side shielding part and a housing which covers the housing of the load device.

### Advantageous Effects of Invention

According to the present invention, a technique to reduce the unnecessary radiated electromagnetic fields in the resonance-type non-contact power supply system can be provided.

### Brief Description of Drawings

[Fig. 1] Fig. 1 is a figure to describe the basic principle of a resonance-type non-contact power supply system of the traditional art.
[Fig. 2] Fig. 2 is a figure which schematically shows the construction of the resonance-type non-contact power supply system of Fig. 1 of the traditional art when the resonance-type non-contact power supply system is mounted in a real system.
[Fig. 3] Fig. 3 is a figure to describe that unnecessary radiated electromagnetic fields occur in the resonance-type non-contact power supply system of the traditional art.
[Fig. 4] Fig. 4 is a figure to describe the transmission loss because of the unnecessary radiated electromagnetic fields in the resonance-type non-contact power supply system of the traditional art.
[Fig. 5] Fig. 5 is a schematic block diagram which shows the construction of a resonance-type non-contact power supply system of a first embodiment of the invention.
[Fig. 6] Fig. 6 is a schematic block diagram which shows the construction of a resonance-type non-contact power supply system of a second embodiment of the invention.
[Fig. 7] Fig. 7 is a figure which shows measurement data of the electromagnetic field strength in the traditional resonance-type non-contact power supply system that is the comparative example, according to the second embodiment of the invention.
[Fig. 8] Fig. 8 is a figure which shows measurement data of the electromagnetic field strength in the resonance-type non-contact power supply system, according to the second embodiment of the invention.
[Fig. 9] Fig. 9 is a figure which shows the construction of a system of measuring the electromagnetic field strength in the traditional resonance-type non-contact power supply system that is a comparative example, according to the second embodiment of the invention.
[Fig. 10] Fig. 10 is a figure which shows the construction of a system of measuring the electromagnetic field strength in the resonance-type non-contact power supply system, according to the second embodiment of the invention.

### Description of Embodiments

Below, modes for carrying out the invention (hereinafter referred to as "embodiments") are explained with reference to the figures. The general description of the present embodiments is as follows. In the resonance-type non-contact power supply system, radiated electromagnetic fields in the transmission channels (the transmitting side in particular) are reduced by "a structure of shielding the resonance coils and a structure of shielding the transmission line between the power supply and the resonance coil" and "a method of connecting the transmission line including the shielding structure and the power supply". This system is applicable, for example, to the power supply system in an electric car, and receiving side devices are carried in a vehicle.

In a first embodiment, a technique to cover the area around the transmitting side and the receiving side resonance coils with metal cases which are connected to the outer conductors of coaxial cables is introduced. In a second embodiment, in addition to the construction of the first embodiment, the transmitting side and the receiving side metal cases are covered by metal shields that are larger than the metal cases. Furthermore, the strong electromagnetic field area between the resonance coils is shielded by a large metal plate, the transmitting side coaxial cable is covered with a metal shield, and the metal shield is connected to the large metal shield, so that the metal shield that covers the coaxial cable is connected to the housing of the high frequency power supply. By adopting such a construction, the electromagnetic field along the FG (Frame Ground) line /AC cable or the electromagnetic field around the housing of the high frequency power supply can be reduced. The first and the second embodiments are described specifically as follows.

### <First embodiment>

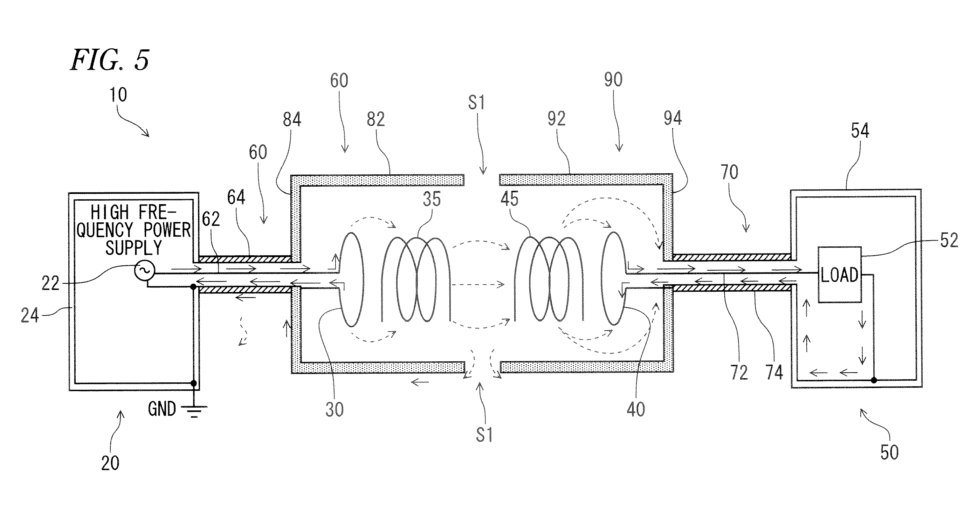

Fig. 5 is a figure which schematically shows the construction of a resonance-type non-contact power supply system 10 of the present embodiment. The resonance-type non-contact power supply system 10 is different from the resonance-type non-contact power supply system 510 of Fig. 3 or Fig. 4 in that a transmitting side metal shield 80 and a receiving side metal shield 90 are provided. Other components are the same, and the same components are given the same reference numerals. Because the technique disclosed in the reference document 1 can be used to explain the electric power transmission principle of the resonance-type non-contact power supply system, the detailed description is omitted here.

The resonance-type non-contact power supply system 10 includes a high frequency power supply 20, a primary coil 30 and a primary resonance coil 35 as transmitting side (primary) devices. The primary coil 30 is connected to the high frequency power supply 20 by using a transmitting side coaxial cable 60. More specifically, the high frequency power supply 20 includes an oscillation source 22 inside a power supply housing 24, and is connected to the primary coil 30 by the transmitting side coaxial cable 60. The power supply housing 24 is grounded to a ground GND. To ground the power supply housing 24, an exclusive ground line may be used, or an AC cable FG line or the like may be used. It is described that the system 10 includes the high frequency power supply 20, but the system may be constructed without the high frequency power supply 20. In this case, it is preferable that the system 10 is so constructed that a suitable high frequency power supply outside the system 10 is connectable and electric power from the high frequency power supply may be received.

The resonance-type non-contact power supply system 10 includes the transmitting side metal shield 80 to cover the area around the primary coil 30 and the primary resonance coil 35. The transmitting side metal shield 80, for example, has an opening towards the receiving side (secondary; right side in the figure), has a cylindrical or cubical shape, and is made of metal (good conductor) such as steel or copper. That is, a shield side wall 82 of the transmitting side metal shield 80 completely covers the area around the primary coil 30 and the primary resonance coil 35 except the opening.

A shield bottom 84 of the transmitting side metal shield 80 is provided with a transmission opening for the transmission channel between the high frequency power supply 20 and the primary coil 30, and the transmitting side coaxial cable 60 is connected to the transmission opening. More specifically, one end (at the right side in the figure) of a coaxial cable outer conductor 64 of the transmitting side coaxial cable 60 is connected to the shield bottom 84 of the transmitting side metal shield 80. The other end (at the left side in the figure) of the coaxial cable outer conductor 64 is connected to the power supply housing 24 of the high frequency power supply 20. A coaxial cable inner conductor 62 directly connects the oscillation source 22 of the high frequency power supply 20 and the primary coil 30.

On the other hand, the resonance-type non-contact power supply system 10 includes a load device 50, a secondary coil 40 and a secondary resonance coil 45 as receiving side (secondary side) devices. A load 52 such as a rectifier or batteries is provided inside a load housing 54 of the load device 50. The load device 50 and the secondary coil 40 are connected by a receiving side coaxial cable 70. It is described that the system 10 includes the load device 50, but the system may be constructed without the load device 50. In this case, it is preferable that the system 10 is so constructed that a suitable load device outside the system 10 is connectable and electric power can be supplied to the load device.

The resonance-type non-contact power supply system 10 includes the receiving side metal shield 90, like the transmitting side metal shield 80 at the transmitting side, to cover the secondary coil 40 and the secondary resonance coil 45. More specifically, the receiving side metal shield 90, for example, has an opening towards the transmitting side (primary; left side in the figure), has a cylindrical tube-like or cubical shape, and is made of metal (good conductor) such as steel or copper. That is, a shield side wall 92 of the receiving side metal shield 90 completely covers the area around the secondary coil 40 and the secondary resonance coil 45 except the opening.

A shield bottom 94 of the receiving side metal shield 90 is provided with a transmission opening for the transmission channel between the load device 50 and the secondary coil 40, and the receiving side coaxial cable 70 is connected to the transmission opening. More specifically, one end (at the left side in the figure) of a coaxial cable outer conductor 74 of the receiving side coaxial cable 70 is connected to the shield bottom 94 of the receiving side metal shield 90. The other end (at the right side in the figure) of the coaxial cable outer conductor 74 is connected to the load housing 54 of the load device 50. A coaxial cable inner conductor 72 is directly connected to the load 52 in the load housing 54.

The operation of the resonance-type non-contact power supply system 10 of the above-mentioned construction is described. The oscillation source 22 oscillates at a high frequency of, for example, several MHz to several 10MHz, and the oscillation output is supplied to the primary coil 30. The primary resonance coil 35 amplifies the electric power of the primary coil 30, and produces an electromagnetic field towards the secondary resonance coil 45. The secondary resonance coil 45 is coupled with the electromagnetic field that is produced by the primary resonance coil 35, and produces an induced current to the secondary coil 40. As a result, the electric power is supplied to the load 52.

At this time, because, at the transmitting side of the above described traditional resonance-type non-contact power supply system 510, an induced current flows to the ground GND through not only the inner side of the coaxial cable outer conductor 64 of the transmitting side coaxial cable 60 but also the outer side of the coaxial cable outer conductor 64, a radiated electromagnetic field occurs around the transmitting side coaxial cable 60. Because, at the receiving side of the resonance-type non-contact power supply system 510, all of the electromagnetic field from the secondary resonance coil 45 is not coupled with the secondary coil 40, part of the electromagnetic field is coupled with the coaxial cable outer conductor 74, and an induced current, which becomes a transmission loss, occurs, a radiated electromagnetic field occurs around the receiving side coaxial cable 70 as a result.

However, in the present embodiment, collection of transmission energy inside the transmitting side coaxial cable 60 and the receiving side coaxial cable 70 is improved. That is, because the area around the transmitting side (primary) resonance part (the primary coil 30 and the primary resonance coil 35) is covered by the transmitting side metal shield 80, and the transmitting side metal shield 80 and the coaxial cable outer conductor 64 of the transmitting side coaxial cable 60 are electrically connected, the electric current which flows out to the outside of the coaxial cable outer conductor 64 at the transmitting side can be collected at the inner side of the coaxial cable outer conductor 64. Although the electromagnetic field may leak out from the space S1 between the transmitting side metal shield 80 and the receiving side metal shield 90 to the outside, the electromagnetic field can be significantly reduced as compared to before. Therefore, the radiated electromagnetic field occurring around the transmitting side coaxial cable 60 or the receiving side coaxial cable 70 becomes very weak. Similarly, because the area around the receiving side (primary) resonance part (the secondary coil 40 and the secondary resonance coil 45) is covered by the receiving side metal shield 90, and the receiving side metal shield 90 and the coaxial cable outer conductor 74 of the receiving side coaxial cable 70 are electrically connected, the electric current which flows out to the outside of the coaxial cable outer conductor 74 at the receiving side can be collected at the inner side of the coaxial cable outer conductor 74. As a result, the transmission efficiency can be improved, and the radiated electromagnetic field can be reduced.

### <Second embodiment>

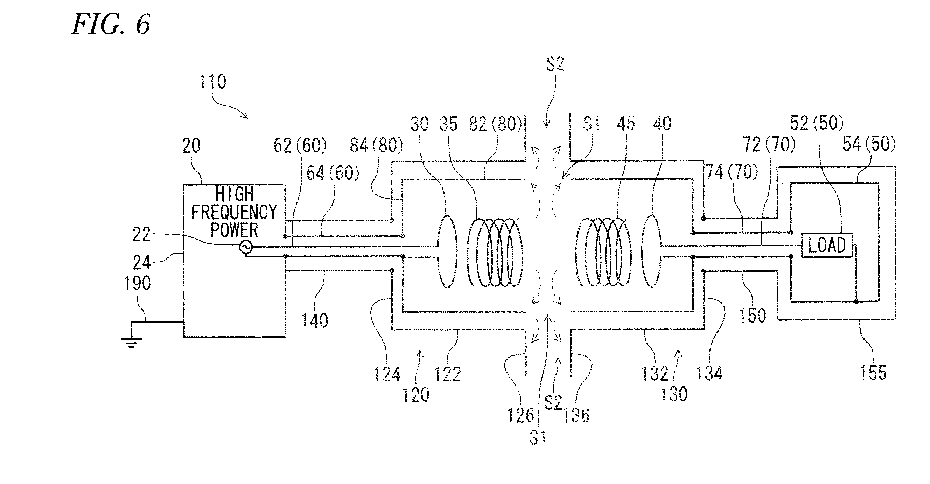

Fig. 6 shows a resonance-type non-contact power supply system 110 according to the present embodiment. The resonance-type non-contact power supply system 110 is a variation of the resonance-type non-contact power supply system 10 described in the first embodiment, and the different point is that the resonance part at the transmitting side (the transmitting side coaxial cable 60, the primary coil 30 and the primary resonance coil 35) and the resonance part at the receiving side (the receiving side coaxial cable 70, the secondary coil 40 and the secondary resonance coil 45) are further covered with shields. With such a construction, leak of the radiated electromagnetic fields can be significantly reduced. Herein, the same components as the above components are given the same reference numerals and their description is omitted, and the different point is mainly described. It is assumed that the FG line of an AC cable 190 is used to ground the high frequency power supply 20.

As shown in the figure, the resonance-type non-contact power supply system 110 additionally includes a transmitting side large metal shield 120 and a coaxial metal shield 140 at the transmitting side, and a receiving side large metal shield 130 and a coaxial metal shield 150 at the receiving side, respectively.

The transmitting side large metal shield 120 is made of metal (good conductor) like the transmitting side metal shield 80, has, for example, a cylindrical or cubical shape and covers the transmitting side metal shield 80. The transmitting side metal shield 80 and the transmitting side large metal shield 120 are so arranged that an electrically insulative state is maintained. The transmitting side metal shield 80 and the transmitting side large metal shield 120 may be simply spaced or the space between the transmitting side metal shield 80 and the transmitting side large metal shield 120 may be filled by an insulator.

The opening side (receiving side; right side in the figure) end of a large shield side surface part 122 is formed with a face-like (circular) large shield front part 126 which is formed by expanding the opening end to the outside. The large shield front part 126 is arranged to face a large shield front part 136 of the receiving side large metal shield 130 to be described later. The sizes of those parts are so formed that the electromagnetic fields at the outer diameter ends become very weak.

One end of the tube-like coaxial metal shield 140 which covers the transmitting side coaxial cable 60 is connected to a large shield bottom part 124. The other end of the coaxial metal shield 140 is connected to the power supply housing 24 of the high frequency power supply 20. The transmitting side coaxial cable 60 and the coaxial metal shield 140 are also so constructed that an insulative state is maintained. The coaxial metal shield 140 should be able to electrically connect the transmitting side large metal shield 120 and the power supply housing 24, and is, for example, a conductor pipe or a pipe of a shield web structure. The coaxial metal shield 140 may have environmental performances such as waterproofing function or the like.

The receiving side large metal shield 130 is made of metal (good conductor) like the receiving side metal shield 90, has, for example, a cylindrical shape and covers the receiving side metal shield 90. The receiving side large metal shield 130 and the receiving side metal shield 90 are so arranged that an electrically insulative state is maintained.

The opening side (transmitting side; left side in the figure) end of a large shield side surface part 132 is formed with a face-like large shield front part 136 which is formed by expanding the opening end to the outside. The large shield front part 136 is arranged to face the large shield front part 126 of the transmitting side large metal shield 120 described above.

One end of the tube-like coaxial metal shield 150 which covers the receiving side coaxial cable 70 is connected to a large shield bottom part 134. The other end of the coaxial metal shield 150 is connected to a housing 155 which covers the load housing 54 of the load device 50. The receiving side coaxial cable 70 and the coaxial metal shield 150 are also so constructed that an insulative state is maintained. The coaxial metal shield 150 should be able to electrically connect the receiving side large metal shield 130 and the housing 155 which covers the load housing 54. The coaxial metal shield 150 also may have environmental performances such as waterproofing function or the like.

According to the resonance-type non-contact power supply system 110 of the above construction, while the same effect as that of the first embodiment is obtained, and the following effect also can be achieved. That is, when the electromagnetic field that leaks from the space S1 between the transmitting side metal shield 80 and the receiving side metal shield 90 are not sufficiently reduced, because the space S2 between the large shield front parts 126 and 136 that face each other can be sufficiently ensured in the outer diameter outward direction, it is possible to sufficiently reduce the strength of the electromagnetic field that leaks.

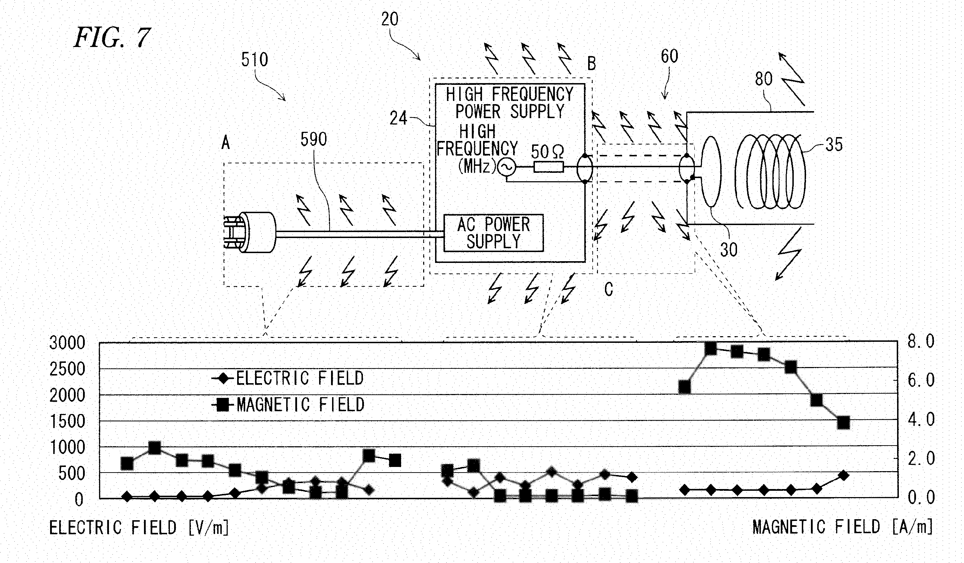

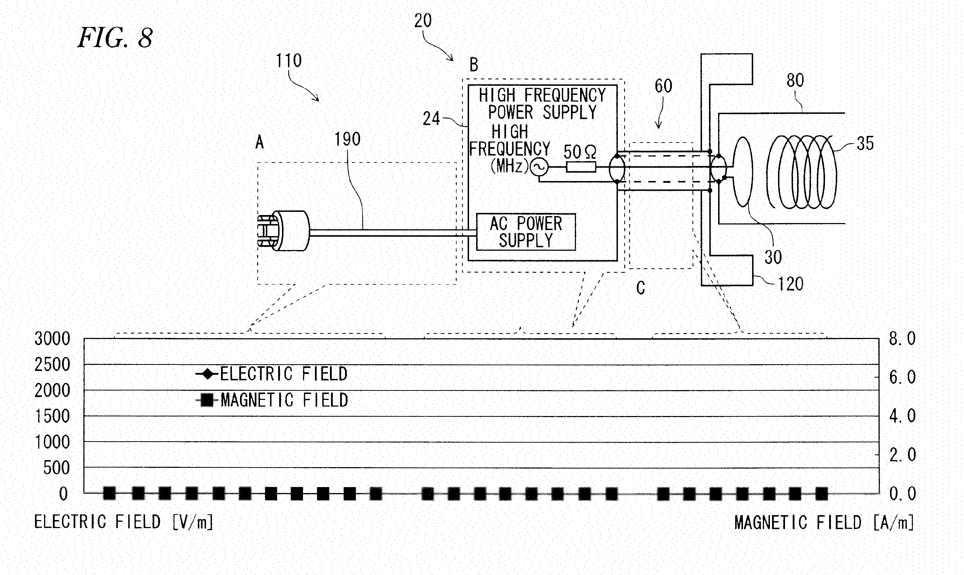

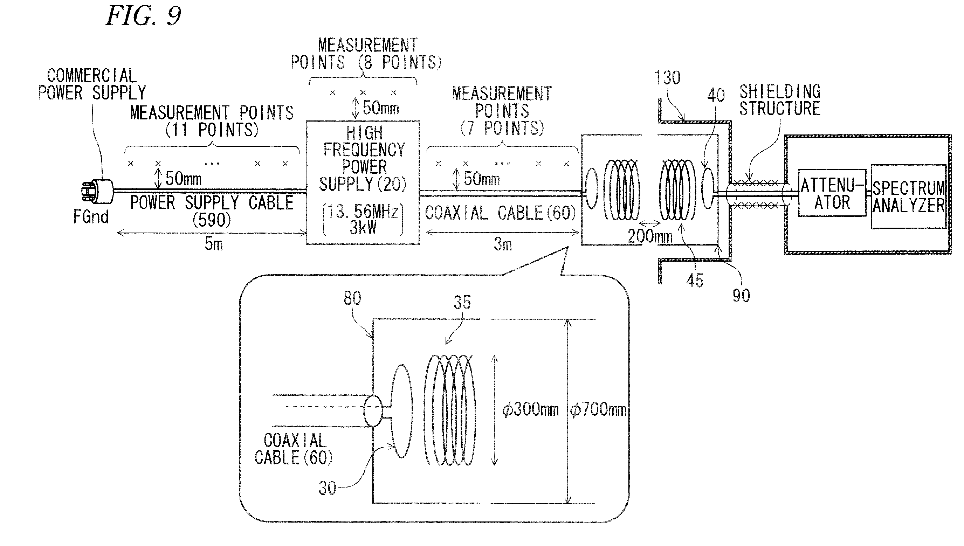

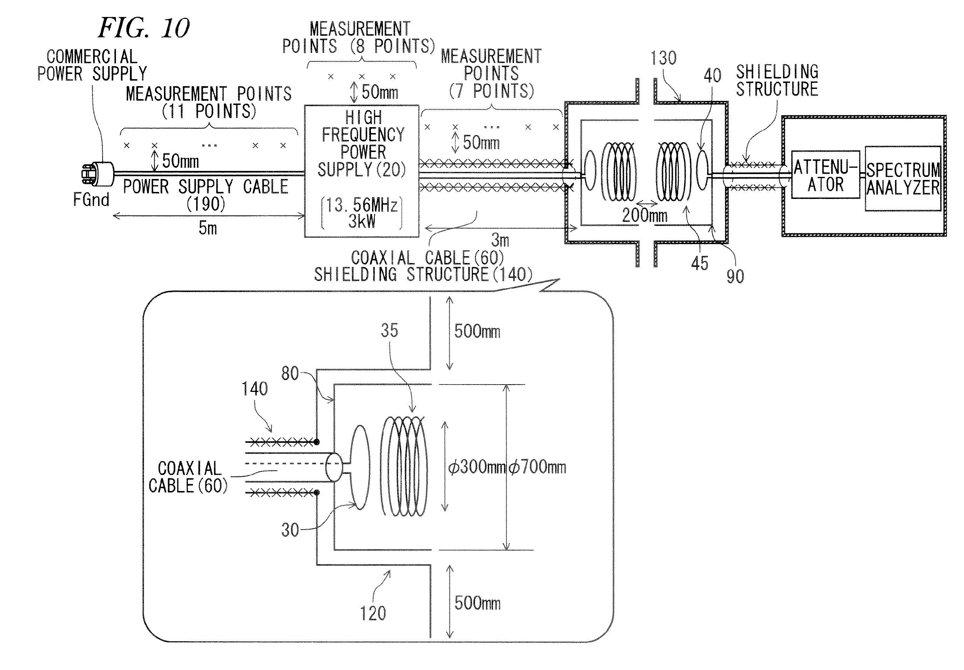

Results of measuring the electromagnetic field strength (electric field and radiated electromagnetic field) are shown in Figs. 7 and 8. Figure 7 shows a measurement result of the resonance-type non-contact power supply system 510 of the traditional art (the same construction as that in Fig. 5) in which the shields are not given. Fig. 8 shows a measurement result of the resonance-type non-contact power supply system 110 of the present embodiment. Herein, the measurement results at the transmitting side (primary side) are shown. Figs. 9 and 10 show the system constructions of measurement systems corresponding to Figs. 7 and 8.

The summaries of the system constructions of the measurement systems are as follows. The following (7) and (8) are only included in Fig. 8.
(1) Power supply cables 590, 190:
   Electric power is supplied to the high frequency power supply by using a power supply cable (5m). There are 11 electromagnetic field measurement spots (spaced 50cm).
(2) High frequency power supply 20:
   The frequency is 13.56MHZ (+-1MHz), and the output power is 3kW. There are 8 electromagnetic field measurement spots (spaced 50cm).
(3) Coaxial cable 60:
   A coaxial cable (3m) is used as a high frequency electric power transmission line and connects the high frequency power supply 20 and the loop coil (the primary coil 30). There are 7 electromagnetic field measurement spots (spaced 50cm).
(4) Loop coils (primary and secondary coils 30, 40):
   The Loop coils are made of copper and have a diameter of 150mm, and the copper wire has a diameter of 5mm. The primary coil 30 at the transmitting side and the secondary coil 40 at the receiving side have the same construction.
(5) resonance coils (primary and secondary loop coils 35, 45):
   The resonance coils have a diameter of 300mm, an inside diameter of 185mm and a pitch of 5mm, and are spiral products made of copper wires which has a diameter of 5mm. The primary loop coil 35 at the transmitting side and the secondary loop coil 45 at the receiving side have the same construction. The coil distance between the primary loop coil 35 and the secondary loop coil 45 at the receiving side is 200mm.
(6) Metal cases (80, 90):
   The transmitting side and receiving side metal shields 80, 90 are connected to the outer conductors (outer jackets) of the coaxial cables 60, 70 to cover the loop coils (30, 40) and the resonance coils (35, 45). The outer diameter is 700mm.
(7) Transmitting side large metal shield 120 (case) <only for the present embodiment>:
   Refer to the enlarged portion in Fig. 10.
(8) Shield structure 1 (the transmitting side) <only for the present embodiment>:
   The transmitting side coaxial cable 60 is covered and the transmitting side large metal shield 120 and the housing 24 of the high frequency power supply 20 are connected. The shielding performance is about 50dB.
(9) Shield structure 2 (the receiving side):
   The receiving side coaxial cable 70 is covered, and the receiving side large metal shield 130 and the housing that covers the measuring equipment (an attenuator and a spectrum analyzer) are connected. The shielding performance is about 50dB.
(10) The attenuator and the spectrum analyzer (load devices):
   The receiving side high frequency electric power is attenuated a predetermined quantity by the attenuator, and a signal level is measured with the spectrum analyzer.

The abstract of the measurement conditions is as follows.
*The resonance-type non-contact power supply system 10 of the present embodiment in which the shielding measures are taken is measured by the measurement system shown in Fig. 10. In contrast, the traditional resonance-type non-contact power supply system 510 in which the shielding measures are not taken is measured by the measurement system shown in Fig. 9.
* Electromagnetic field sensors are installed at measurement points. The vertical distance from the measurement point to the electromagnetic field sensor surface is 50mm.
* Electric power of a frequency of 13.56MHz and 3KW is output from the high frequency power supply 20, and the maximum electric field values and the maximum magnetic field values measured by the electromagnetic field sensors are acquired.
* A result (refer to Fig. 7) when the receiving side shielding measure is not taken and a result (refer to Fig. 8) when the shield measure is taken are acquired and compared in graphs.

The results of the measurements are as follows. As shown in Fig. 7, for the traditional resonance-type non-contact power supply system 510, the electric field and the magnetic field over the whole transmitting side are measured. Particularly, the measurement result of the radiated electromagnetic field around the transmitting side coaxial cable 60 becomes higher. From this, it can be inferred that an induced current which is the cause of the transmission loss occurs at the transmitting side coaxial cable 60.

On the other hand, as shown in Fig. 8, for the resonance-type non-contact power supply system 110 of the present embodiment, neither electric field nor radiated electromagnetic field was substantially measured. That is, it can be recognized that improvement of the transmission efficiency and reduction of the radiated electromagnetic field in the resonance part (the primary coil 30, the primary resonance coil 35, and the transmitting side coaxial cable 60) can be realized.

The present invention is described based on the first and second embodiments as above. These embodiments are illustrative and it is understood by those skilled in the art that it is possible to make various modifications to those components and their combination and that these modifications are also in the scope of the invention. For example, in the above embodiments, the shields are provided to both the transmitting side and the receiving side devices, but the shields may be provided only to either of the devices. With reference to the double shields, it is also possible that only either of the devices is double shielded.

Although the invention is described in detail with reference to specific embodiments, it is apparent that various modifications and amendments may be made by those skilled in the art without departing from the spirit and scope of the invention.

This application is based on the Japanese patent application (patent application 2011-96365) filed on April 22, 2011, whose content is incorporated herein by reference.

### Industrial Applicability

The present invention is useful in the field of resonance-type non-contact power supply systems.

### Reference Signs List

- 10: resonance-type non-contact power supply system
- 20: high frequency power supply
- 22: oscillation source
- 24: power supply housing
- 30: primary coil
- 35: primary resonance coil
- 40: secondary coil
- 45: secondary resonance coil
- 50: load device
- 52: load
- 54: load housing
- 60: transmitting side coaxial cable
- 62, 72: coaxial cable inner conductor
- 64, 74: coaxial cable outer conductor
- 70: receiving side coaxial cable
- 80: transmitting side metal shield
- 82, 92: shield side wall
- 84, 94: shield bottom
- 90: receiving side metal shield
- 120: transmitting side large metal shield
- 122, 132: large shield side surface part
- 124, 134: large shield bottom part
- 130: receiving side large metal shield
- 140, 150: coaxial metal shield
- 155: housing

## Claims

1. A resonance-type non-contact power supply system which comprises a transmitting side resonance coil part and a receiving side resonance coil part, and which transmits electric power by a non-contact resonance effect from the transmitting side resonance coil part to the receiving side resonance coil part, further comprising
a transmitting side coaxial cable which electrically connects a high frequency power supply and the transmitting side resonance coil, and
a good conductor first transmitting side shielding part which covers the transmitting side resonance coil part from the outside,
wherein
an outer conductor of the transmitting side coaxial cable connects the first transmitting side shielding part and a housing of the high frequency power supply.

2. The resonance-type non-contact power supply system according to claim 1, further comprising
a receiving side coaxial cable which electrically connects a load device and the receiving side resonance coil part, and
a good conductor first receiving side shielding part which covers the receiving side resonance coil part from the outside,
wherein
an outer conductor of the receiving side coaxial cable connects the first receiving side shielding part and a housing of the load device.

3. The resonance-type non-contact power supply system according to claim 1 or 2, further comprising
a good conductor second transmitting side shielding part which covers the first transmitting side shielding part from the outside, and
a good conductor transmitting side coaxial cable shielding part which covers the transmitting side coaxial cable and electrically connects the second transmitting side shielding part and the housing of the high frequency power supply.

4. The resonance-type non-contact power supply system according to claim 2, further comprising
a good conductor second transmitting side shielding part which covers the first transmitting side shielding part from the outside,
a good conductor transmitting side coaxial cable shielding part which covers the transmitting side coaxial cable and electrically connects the second transmitting side shielding part and the housing of the high frequency power supply,
a good conductor second receiving side shielding part which covers the first receiving side shielding part from the outside, and
a good conductor receiving side coaxial cable shielding part which covers the receiving side coaxial cable and electrically connects the second receiving side shielding part and a housing which covers the housing of the load device.

5. The resonance-type non-contact power supply system according to claim 4, wherein the second transmitting side shielding part and the second receiving side shielding part comprise surfaces which extend outwards respectively from the ends of the second transmitting side shielding part and the second receiving side shielding part that face each other.

6. A resonance-type non-contact power supply system which comprises a transmitting side resonance coil part and a receiving side resonance coil part, and which transmits electric power by a non-contact resonance effect from the transmitting side resonance coil part to the receiving side resonance coil part, further comprising
a receiving side coaxial cable which electrically connects a load device and the receiving side resonance coil part, and
a good conductor first receiving side shielding part which covers the receiving side resonance coil part from an outside,
wherein
an outer conductor of the receiving side coaxial cable connects the first receiving side shielding part and a housing of the load device.

7. The resonance-type non-contact power supply system according to claim 6, further comprising
a good conductor second receiving side shielding part which covers the first receiving side shielding part from the outside, and
a good conductor receiving side coaxial cable shielding part which covers the receiving side coaxial cable and electrically connects the second receiving side shielding part and a housing which covers the housing of the load device.
